# EUROPEAN PATENT SPECIFICATION

(11) **EP 1 561 370 B1**
(45) Date of publication and mention of the grant of the patent: **09.04.2008**
(21) Application number: 03751209.2
(22) Date of filing: 27.10.2003
(51) Int. Cl.: H05K 13/00

(54) **COMPONENT PLACEMENT MACHINE AS WELL AS A METHOD FOR TRANSPORTING PRINTED CIRCUIT BOARDS**
BESTÜCKUNGSAUTOMAT FÜR BAUELEMENTE SOWIE VERFAHREN ZUM TRANSPORTIEREN VON LEITERPLATTEN
MACHINE POUR METTRE EN PLACE DES COMPOSANTS ET PROCEDE POUR TRANSPORTER DES CARTES DE CIRCUITS IMPRIMES

(30) Priority: 13.11.2002 EP 02079757
(43) Date of publication of application: 10.08.2005
(73) Proprietor: Assembléon B.V., 5503 LA Veldhoven (NL)
(72) Inventor: VAN HALDER, Lambertus, C., J., NL-5503 LA Veldhoven (NL); VAN DER HORST, Adrianus, J., J., NL-5656 AA Eindhoven (NL); VAN DEURSEN, Johannes, A., M., NL-5503 LA Veldhoven (NL); PEIJSTER, Jerry, J., M., NL-5503 LA Veldhoven (NL); BROEKHUIZEN, Hendrik, NL-5503 LA Veldhoven (NL); BAARTMAN, Jan, P., NL-5503 LA Veldhoven (NL)
(74) Representative: Valkonet, Rutger
(86) International application number: PCT/IB2003/004752
(87) International publication number: WO 2004/045266

(56) References cited:
- US-A1- 2002 085 901
- US-B1- 6 324 752

## Description

The invention relates to a component placement machine with a frame and with a transport device for transporting printed circuit boards in an X-direction, which transport device comprises at least one transport beam extending in the X-direction, which beam can be driven in the X-direction in a reciprocating movement.

The invention further relates to a method for transporting printed circuit boards with respect to a frame by means of a transport beam in an X-direction whereby at least one printed circuit board is moved by means of the transport beam from an initial position in a positive X-direction to a predetermined position, after which the transport beam is lowered with respect to the printed circuit board in a negative Z-direction over a predetermined distance, the transport beam is moved in the negative X-direction to the initial position and the transport beam is moved up again in the positive Z-direction over the predetermined distance.

Such a machine as well as such a method are disclosed in US-A-5.680.699 in which printed circuit boards in the form of strip shaped supports are being transported and provided with electronic components. The strip shaped support or foil is on one lateral edge provided with holes through which transport pins of a transport beam are being inserted. The transport beam is further provided with a clamping mechanism which extends along the other lateral edge of the foil. By means of the clamping mechanism the foil is tautened in an Y-directed extending perpendicular to the X-direction and lying in the plane of the foil.

When the foil has been displaced in the X-direction over the desired distance, the clamping means are being released, the transport pins are being lowered and the transport beam is displaced in a negative X-direction whilst the foil is lying with its lower surface on a supporting plate forming part of the frame.

In view of the high accuracy with which components have to be placed it is desirable to transport the printed circuit board by means of clamping means. Furthermore no specific transport holes need to be provided in the printed circuit board, so that more freedom in the design of the board is obtained.

This machine is, however, not suitable for printed circuit boards which are already provided with components on its lower surface.

It is therefore an object of the invention to provide a component placement machine in which the above mentioned disadvantage has been overcome.

This object has been achieved by the component placement machine according to the invention in that the transport device is provided with clamping means connected to the transport beam for clamping in at least one lateral edge extending in the X-direction of the printed circuit boards to be transported, and in that the device is further provided with supporting means connected to the frame for supporting two lateral edges on both sides of the printed circuit boards, which clamping means can be brought into an active clamping position such that the clamping means are active during the movement of the transport beam in the positive X-direction and can be brought in a rest position during returning of the transport beam in the negative X-direction, in which rest position of the clamping means the printed circuit boards are being supported by the supporting means.

Because the printed circuit board in the rest position of the clamping means, is being supported on the two lateral edges by the supporting means, the components connected to the lower surface of the printed circuit board do not form obstacles for the supporting means.

Furthermore the supporting means on which the printed circuit boards simply rest, do not exert undesired forces on the printed circuit boards, due to which the boards might be moved. In this manner a good position accuracy is obtained.

An embodiment of the component placement machine according to the invention is characterized in that the clamping means comprise a fixed jaw portion, which cooperates with an upper side of the printed circuit board and a moveable jaw portion which is movable in a Z-direction to the fixed jaw portion to cooperate with a lower side of the printed circuit board and is movable away from the fixed jaw portion to release the printed circuit board.

Due to the movable jaw portion it is relatively easy to clamp a lateral edge of the printed circuit board. Furthermore by lowering the movable jaw portion with respect to the fixed jaw portion, the printed circuit board, resting on the movable jaw portion is also lowered, whereby the lateral edges of the printed circuit board can easily be put on the supporting means connected to the frame.

Another embodiment of the component placement machine according to the invention is characterized in that the fixed jaw portion comprises a number of clamping elements which extend in an X-direction one behind the other.

The use of clamping elements with dimensions smaller than a dimension of each of the printed circuit boards will achieve that each of the printed circuit boards will always be clamped in by at least two clamping elements. If the clamping element is spring loaded and comprises for example a leaf spring, differences in thickness of the printed circuit boards will easily be taken into account.

Another preferred embodiment of the component placement machine according to the invention is characterized in that the transport device comprises a bed of supporting pins, movable simultaneously with the movable jaw portion.

The supporting pins support the printed circuit board during transport and are located against the lower surface of the printed circuit board on locations where no components are present. Furthermore the support pins prevent deflection of the printed circuit board.

By simultaneously moving the movable jaw portion as well as the supporting pins, a good support for the printed circuit board is obtained both during the transport of the printed circuit board in the positive X-direction as well as during the lowering of the printed circuit board and placing it on the supporting means connected to the frame.

It is also an object of the invention to provide a method for transporting printed circuit boards whereby the transport beam can be returned to its initial position relatively quickly.

This object is being achieved by the method according to the invention in that the movement of the transport beam in the negative X-direction as well as the Z-direction is partly simultaneously.

If the transport beam is already start moving in the negative X-direction before the transport beam has been displaced in the negative Z-direction over the predetermined distance, a time reduction is being obtained. The transport beam can be moved in the negative X-direction as soon as all the elements of the transport beam which might hit against components on the lower surface of the printed circuit board are lowered enough to avoid collision. If use is being made of supporting pins, the supporting pins must be lower over safety distance which is larger than the height of the biggest component connected to the lower surface of the printed circuit board. This safety distance therefore depends on the specific printed circuit board which is provided with components in the component placement machine. The safety distance is therefore preferably adjustable. In the same manner the transport beam can be moved in a positive Z-direction from the predetermined distance to the safety distance as soon as the transport beam is near its initial position. As soon as the transport beam is at its initial position in X-direction, the transport beam can be moved upwards and the supporting pins are brought against the lower surface of the printed circuit board.

The invention will now be explained in more detail below with reference to the drawing, in which embodiments of the component placement machines according to the invention are shown by way of example.

Fig. 1 shows a front view of a component placement machine according to the invention,

Fig. 2 shows a schematic side view of the machine as shown in fig. 1,

Fig. 3 shows a detailed part of the side view as shown in fig. 2,

Fig. 4 shows several steps for transporting printed circuit board according to the invention,

Fig. 5 shows a graph of the movement of the transport beam of the machine as shown in fig. 1.

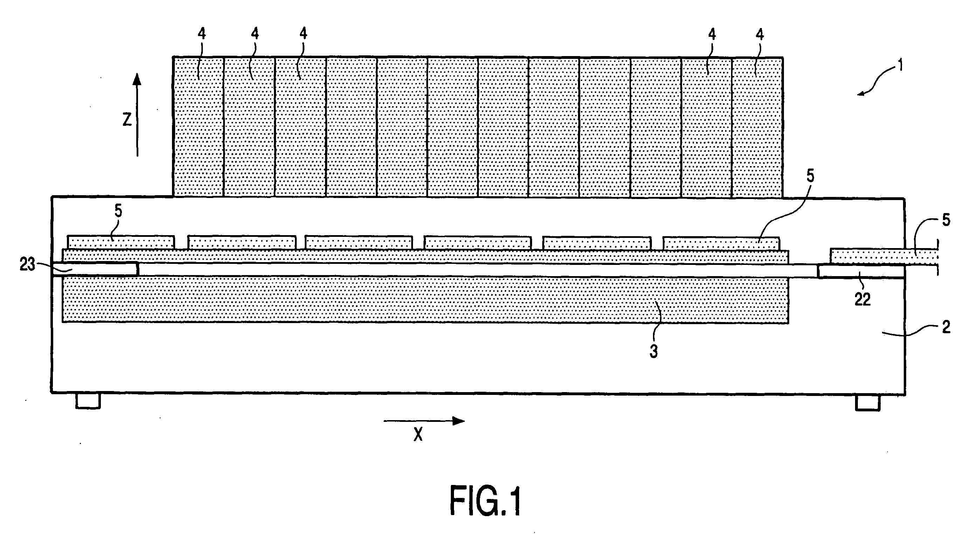

Fig. 1 shows a component placement machine 1 according to the invention which is provided with a frame 2 in which a transport device 3 is accommodated. The component placement machine 1 is further provided with a number of component placement units 4. Such units 4 are known for example from the above mentioned US-patent US-A-5.680.699. Printed circuit boards 5 can be transported through the machine 1 by the transport device 3. The transport device 3 can be indexed over a certain distance in a positive X-direction by driven means (not shown), whereupon the transport device 3 can be moved back into its initial or starting position in the negative X-direction after said distance has been covered. The printed circuit boards, transported by means of the transport device 3 are provided with components by the units 4.

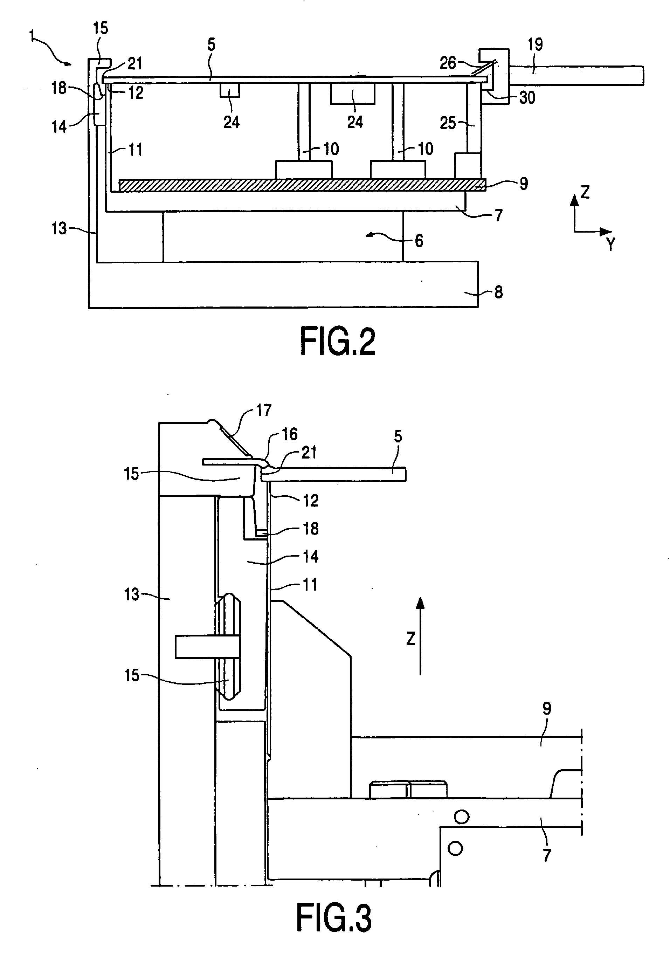

Fig. 2 and 3 show a side view of the component placement machine 1 and especially the transport device 3. The transport device 3 comprises a transport beam 6 which comprises two plates 7, 8 extending parallel to each other. The plate 7 is movable with respect to plate 8 in and opposite to the Z-direction. The plate 7 carries a plate 9 on which supporting pins 10 are mounted. On one lateral side the plate 7 is provided with a metal sheet 11 extending perpendicular to the plate 7. An edge 12 of the metal sheet 11 lies on the same height as the ends of the supporting pins 10. The plate 8 of the transport beam 6 is provided on a lateral edge with a plate 13 extending parallel to the metal plate 11. The plate 13 is slidable mounted with respect to a guiding strip 14, connected to the frame 2. As can be seen in fig. 3 the plate 13 is thereto provided with a set of wheels 15 forming guiding means with respect to the guiding strip 14. By means of slidable mounted plate 13, the guiding strip 14 will be positioned in Y- and Z-direction. By means of slidably mounted plate 13 the whole transport beam 6 can be moved in and opposite to the X-direction.

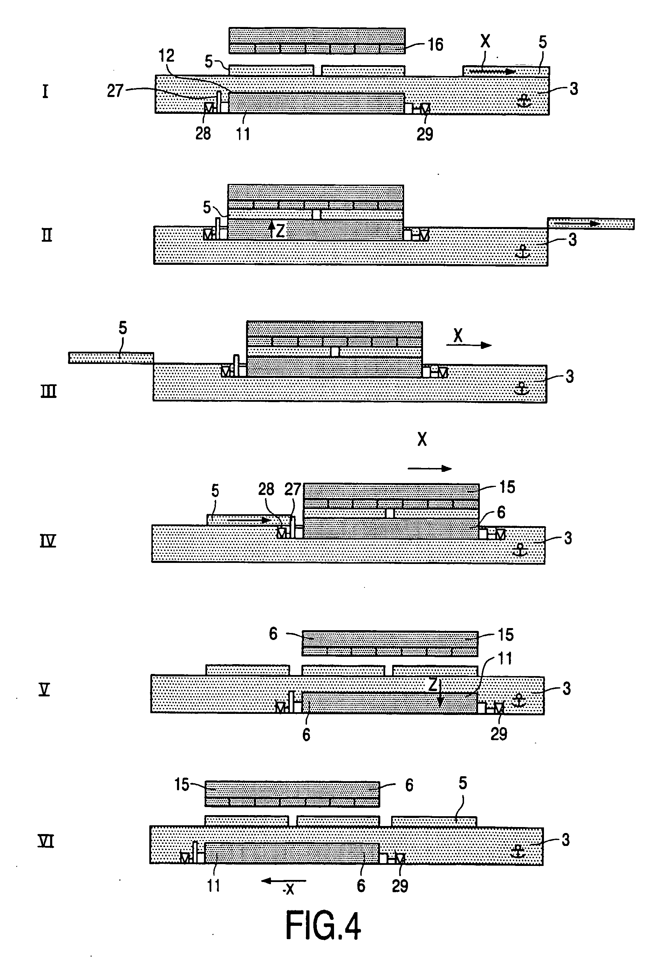

The plate 13 is provided on a side remote from the plate 8 with a part 15 extending parallel to the plate 8 and above the edge 12 of the plate 11. The part 15 forms a first jaw portion cooperating with the edge 12 forming a second jaw portion of clamping means. Between said jaw portions 12, 15 the printed circuit board 5 can be clamped. The part 15 is, as can be seen in fig. 3 and 4, provided with a number of clamping elements 16 which extend in an X-direction one behind the other and are connected by means of leaf springs 17 to the part 15.

On a lateral side remote from the knife shaped thin plate 11, a relatively thin plate 25 is mounted on the plate 9 which plate 25 extends to the same height as the ends of the supporting pins 10. The plate 25 supports a components free lateral zone of for example 3 mm of the printed circuit board 5.

The guiding strip 14 is on a side directed to the part 15 provided with a ridge 18 forming part of supporting means for the printed circuit board 5. The supporting means for the printed circuit board 5 comprises furthermore an element 19 which is movable in and opposite to the Y-direction to be able to support printed circuit boards 5 with different width. The element 19 is provided with a ridge 20 lying on the same height as the ridge 18.

The element 19 is furthermore provided with a spring loaded element 26 which presses the printed circuit board 5 against the plate 25. During transport the printed circuit boards 5 slide along the spring loaded element 26.

The operation of the machine will now be explained with reference to fig. 4 in which several steps I-VI are shown for transporting a printed circuit board 5. In step I three printed circuit boards 5 are located in the machine 1 and are resting with their lateral edges on the ridges 18, 20 of the supporting means. The plate 7 of the transport beam 6 as well as the plate 11 connected thereto is located in a relatively low position whereby the edge 12 is located under the level of the ridges 18, 20.

In step II the plate 7 of the transport beam 6 together with the plate 11 and the supporting pins 10 has been moved in the positive Z-direction whereby lateral edges 21 (see fig. 3) of two boards 5 are clamped in between the edge 12 of the plate 11 and the clamping elements 16.

The lateral edges of the printed circuit board necessary for being supported and being clamped in need to be free from components. This component-free lateral zone is for example 3 mm.

As can be seen in fig. 4, each printed circuit board 5 is clamped in by several clamping elements 16, the length of which being smaller than the longitudinal dimension of the printed circuit board. It is achieved thereby that each of the printed circuit boards will be satisfactorily be clamped in by at least one clamping element in spite of possible thickness differences among the printed circuit boards. As can be further seen, in step II the printed circuit board 5 on the right side is being removed from the machine 1, for example by means of an endless belt 22 as shown in fig. 1.

In step III the transport beam 6 together with the clamped in circuit boards 5 is transported in X-direction. The transport in X-direction can be stepwise so that each printed circuit board 5 will stop under each component placement unit 4 to provide it with components. Before a component is placed on the printed circuit board 5, the exact position of the board 5 with respect to the component placement unit 4 can be determined by means of a camera mounted on the unit 4.

In step IV the transport beam 6 has reached a position in which a printed circuit board 5 is located near the end of the transport device 3. A new printed circuit board 5 can now be brought in by means of, for example an endless belt 23 (see fig. 1).

The transport beam 6 is provided near the left side with a stopper 27 to which the new printed circuit board 5 transported by the endless belt 23 will abut. As soon as the new board 5 is near the stopper 27, an optical sensor 28 will detect it and send a signal to the driven means of the endless belt 23 to reduce its speed so that the board 5 will slowly abut against the stopper 27. The stopper can be displaced from the left side to the right side in case that the machine 1 will be driven in the opposite direction. On the right side 29 an optical sensor 29 is also mounted on the transport beam 6. By means of said optical sensor 29 it is possible to detect a printed circuit board 5 on the right side of the transport beam 6. If said printed circuit board 5 has not yet been removed and is detected by the optical sensor 29 an upward movement of the transport beam 6 can be stopped to prevent damage to the machine and/or the printed circuit board.

As shown in step V the plate 7 together with the plate 11 and the transport pins 10 is moved in negative Z-direction whereby the printed circuit boards 5 will also move downwards until the lateral edges of the printed circuit board 5 abut the ridges 18, 20 of the supporting means and will rest thereon. Now the transport beam 6 can be moved in negative X-direction until it has reached the initial position as shown in step I. The cycle of transporting printed circuit boards 5 can now be started again.

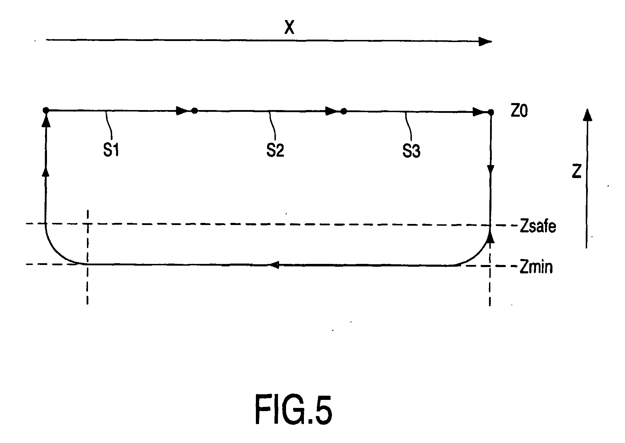

In fig. 5 a graph is shown in which the movement of the transport beam 6 and especially the plate 7 and the metal plate 11 connected thereto is shown. First, the transport beam 6 is indexed in several steps S1, S2 and S3 to transport the printed circuit boards 5. Then the plate 11 is moved in negative Z-direction to a safety distance at level Zsafe on which level the supporting pins 10 are located below all components 24 connected to the lower surface of the printed circuit board 5. As soon as the plate 11 and the supporting pins 10 has reached the level Zsafe, the transport beam 6 start moving in negative X-direction whilst the plate 11 continues moving in negative Z-direction until it has reached the level Zmin. Due to this combined movement, the time necessary for the movement of the transport beam 6 back to the initial position is reduced. As soon as the transport beam 6 reaches it initial position, the plate 7 and the plate 11 are being moved upwards to the level Zsafe. When the transport beam 6 has reached its initial position, the plate 11 is moved beyond the Zsafe level to the initial Z0-leve on which the printed circuit board 5 is supported by the transport pins 10 and clamped in between the edge 12 of the plate 11 and the spring loaded clamping elements 16. Also due to the combined movement in negative X- and positive Z-direction near the initial position of the transport beam 6 a reduction of the time necessary for the return movement of the transport beam 6 has been achieved.

The positive X-direction can be directed to the right side of the machine 1 as well as to the left side.

The predetermined position to which the transport beam 6 is indexed is programmable. Also the steps S1, S2 etc. are programmable.

It is also possible to clamp in the printed circuit boards 5 on both lateral edges during transport.

## Claims

1. A component placement machine (1) with a frame and with a transport device (3) for transporting printed circuit boards (5) in an X-direction, which transport device (3) comprises at least one transport beam (6) extending in the X-direction, which beam (6) can be driven in the Xdirection in a reciprocating movement, **characterized in that** the transport device (3) is provided with clamping means (12, 15) connected to the transport beam (6) for clamping in at least one lateral edge extending in the X-direction of the printed circuit boards (5) to be transported, and **in that** the device is further provided with supporting means (18, 20) connected to the frame for supporting two lateral edges on both sides of the printed circuit boards, which clamping means (12, 15) can be brought into an active clamping position such that the clamping means (12, 15) are active during the movement of the transport beam (6) in the positive X-direction and can be brought in a rest position during returning of the transport beam (6) in the negative X-direction, in which rest position of the clamping means (12, 15), the two lateral edges of the printed circuit boards (5) rest on the supporting means (18, 20).

2. A component placement machine (1) according to claim 1, **characterized in that** the clamping means (12, 15) comprise a fixed jaw portion, which cooperates with an upper side of the printed circuit board and a moveable jaw portion which is movable in aZ-direction to the fixed jaw portion to cooperate with a lower side of the printed circuit board and is movable away from the fixed jaw portion to release the printed circuit board.

3. A component placement machine (1) according to claim 2, **characterized in that** the fixed jaw portion comprises a number of clamping elements which extend in an Xdirection one behind the other.

4. A component placement machine (1) according to claim 3, **characterized in that** each clamping element comprises a leaf spring.

5. A component placement machine (1) according to claims 2-4, **characterized in that** the transport device (3) comprises a bed of supporting pins, movable simultaneously with the movable jaw portion.

6. A component placement machine (1) according to one of the preceding claims, **characterized in that** the supporting means (18, 20) comprises two ridges extending in the X-direction.

7. A component placement machine (1) according to claim 6, **characterized in that** the distance between the ridges is adjustable.

8. Method for transporting printed circuit boards (5) with respect to a frame by means of a transport beam (6) in an X-direction whereby at least one printed circuit board is moved by means of the transport beam (6) from an initial position in a positive X-direction to a predetermined position, after which the transport beam (6) is lowered with respect to the printed circuit board in a negative Z-direction over a predetermined distance, the transport beam (6) is moved in the negative X-direction to the initial position and the transport beam (6) is moved up again in the positive Z-direction over the predetermined distance, **characterized in that** the movement of the transport beam (6) in the negative X-direction as well as the Z-direction is partly simultaneously.

9. Method according to claim 8, **characterized in that** the movement of the transport beam (6) in the negative X-direction is started as soon as the transport beam (6) has been moved in the negative Z-direction over a safety distance but before the transport beam (6) has been moved in the negative Z-direction over the predetermined distance.

10. Method according to claim 8, **characterized in that** the movement of the transport beam (6) in the positive Z-direction is started before the transport beam (6) is at the initial position in X-direction but only after the transport beam (6) has reached the initial X-position the transport beam (6) will be moved from a safety distance to the initial position in Z-direction.

11. Method according to one of the preceding claims 9 or 10, **characterized in that** the safety distance is adjustable.

## Patentansprüche

1. Bauelementbestückungsmaschine (1) mit einem Rahmen und mit einer Transportvorrichtung (3) zum Transportieren von Leiterplatten (5) in einer X-Richtung, wobei die Transportvorrichtung (3) wenigstens einen Transportbalken (6) aufweist, der sich in der X-Richtung erstreckt, wobei der Balken (6) in der X-Richtung in einer Hin- und Herbewegung angetrieben werden kann, **dadurch gekennzeichnet, dass** die Transportvorrichtung (3) mit Klemmeinrichtungen (12, 15) versehen ist, die mit dem Transportbalken (6) verbunden sind, zum Einklemmen von wenigstens einem sich in der X-Richtung erstreckenden Seitenrand der zu transportierenden Leiterplatten (5) und dass die Vorrichtung weiter mit einer Trageinrichtung (18, 20) versehen ist, die mit dem Rahmen verbunden ist, zum Tragen von zwei Seitenrändern auf beiden Seiten der Leiterplatten, wobei die Klemmeinrichtungen (12, 15) in eine aktive Klemmposition gebracht werden können, so dass die Klemmeinrichtungen (12, 15) während der Bewegung des Transportbalkens (6) in der positiven X-Richtung aktiv sind, und während des Zurückbewegens des Transportbalkens (6) in der negativen X-Richtung in eine Ruheposition gebracht werden können, in der die Klemmeinrichtungen (12, 15) die beiden Seitenränder der Leiterplatten (5) auf der Trageinrichtung (18, 20) ruhen.

2. Bauelementbestückungsmaschine (1) nach Anspruch 1, **dadurch gekennzeichnet, dass** die Klemmeinrichtungen (12, 15) einen festen Backenteil aufweisen, der mit einer oberen Seite der Leiterplatte zusammenwirkt, und einen beweglichen Backenteil, der in einer Z-Richtung zu dem festen Backenteil hin bewegbar ist, um mit einer unteren Seite der Leiterplatte zusammenzuwirken, und von dem festen Backenteil wegbewegbar ist, um die Leiterplatte freizugeben.

3. Bauelementbestückungsmaschine (1) nach Anspruch 2, **dadurch gekennzeichnet, dass** der feste Backenteil eine Anzahl von Klemmelementen aufweist, die sich eines hinter dem anderen in einer X-Richtung erstrecken.

4. Bauelementbestückungsmaschine (1) nach Anspruch 3, **dadurch gekennzeichnet, dass** jedes Klemmelement eine Blattfeder umfasst.

5. Bauelementbestückungsmaschine (1) nach den Ansprüchen 2-4, **dadurch gekennzeichnet, dass** die Transportvorrichtung (3) ein Bett von Tragstiften aufweist, die gleichzeitig mit dem beweglichen Backenteil bewegbar sind.

6. Bauelementbestückungsmaschine (1) nach einem der vorhergehenden Ansprüche, **dadurch gekennzeichnet, dass** die Trageinrichtung (18, 20) zwei Leisten umfasst, die sich in der X-Richtung erstrecken.

7. Bauelementbestückungsmaschine (1) nach Anspruch 6, **dadurch gekennzeichnet, dass** der Abstand zwischen den Leisten einstellbar ist.

8. Verfahren zum Transportieren von Leiterplatten (5) in Bezug auf einen Rahmen mit Hilfe eines Transportbalkens (6) in einer X-Richtung, wodurch wenigstens eine Leiterplatte mit Hilfe des Transportbalkens (6) aus einer Ausgangsposition in einer positiven X-Richtung in eine vorbestimmte Position bewegt wird, woran anschließend der Transportbalken (6) in Bezug auf die Leiterplatte in einer negativen Z-Richtung über eine vorbestimmte Strecke abgesenkt wird, der Transportbalken (6) in der negativen X-Richtung in die Ausgangsposition bewegt wird und der Transportbalken (6) wieder aufwärts in der positiven Z-Richtung über die vorbestimmte Strecke bewegt wird, **dadurch gekennzeichnet, dass** die Bewegung des Transportbalkens (6) in der negativen X-Richtung sowie in der Z-Richtung teilweise gleichzeitig ist.

9. Verfahren nach Anspruch 8, **dadurch gekennzeichnet, dass** die Bewegung des Transportbalkens (6) in der negativen X-Richtung begonnen wird, sobald sich der Transportbalken (6) in der negativen Z-Richtung über eine sichere Distanz bewegt hat, aber bevor der Transportbalken (6) in der negativen Z-Richtung über die vorbestimmte Distanz bewegt worden ist.

10. Verfahren nach Anspruch 8, **dadurch gekennzeichnet, dass** die Bewegung des Transportbalkens (6) in der positiven Z-Richtung begonnen wird, bevor der Transportbalken (6) in der Ausgangsposition in X-Richtung ist, aber erst, nachdem der Transportbalken (6) die Ausgangs-X-Position erreicht hat, wird der Transportbalken (6) aus einer Sicherheitsdistanz zu der Ausgangsposition in Z-Richtung bewegt.

11. Verfahren nach einem der vorhergehenden Ansprüche 9 oder 10, **dadurch gekennzeichnet, dass** die Sicherheitsdistanz einstellbar ist.

## Revendications

1. Machine pour mettre en place des composants (1) avec un châssis et un dispositif de transport (3) pour acheminer des cartes de circuit imprimé (5) dans une direction X, lequel dispositif de transport (3) comprend au moins une poutre de transport (6) s'étendant dans la direction X, laquelle poutre (6) peut être entraînée dans la direction X selon un mouvement de va-et-vient, **caractérisée en ce que** le dispositif de transport (3) est équipé de moyens de bridage (12, 15) raccordés à la poutre de transport (6) pour brider au moins un bord latéral s'étendant dans la direction X des cartes de circuit imprimé (5) à transporter, et **en ce que** le dispositif est de plus muni de moyens de support (18, 20) raccordés au châssis pour supporter deux bords latéraux des deux côtés des cartes de circuit imprimé, lesquels moyens de bridage (12, 15) peuvent être amenés dans une position de bridage active, de telle sorte que les moyens de bridage (12, 15) sont actifs pendant le mouvement de la poutre de transport (6) dans la direction X positive et peuvent être mis dans une position de repos pendant le retour de la poutre de transport (6) dans la direction X négative, dans laquelle position de repos les moyens de bridage (12, 15), les deux bords latéraux des cartes de circuit imprimé (5) reposent sur les moyens de support (18, 20).

2. Machine de mise en place de composants (1) selon la revendication 1, **caractérisée en ce que** les moyens de bridage (12, 15) comprennent une portion de mâchoire fixe, qui coopère avec un côté supérieur de la carte de circuit imprimé, et une portion de mâchoire mobile, qui est mobile dans une direction Z par rapport à la portion de mâchoire fixe, pour coopérer avec un côté inférieur de la carte de circuit imprimé et se déplace en s'écartant de la portion de mâchoire fixe pour libérer la carte de circuit imprimé.

3. Machine de mise en place de composants (1) selon la revendication 2, **caractérisée en ce que** la portion de mâchoire fixe comprend un certain nombre d'éléments de bridage qui s'étendent dans une direction X l'un derrière l'autre.

4. Machine de mise en place de composants (1) selon la revendication 3, **caractérisée en ce que** chaque élément de bridage comprend un ressort à lame.

5. Machine de mise en place de composants (1) selon les revendications 2-4, **caractérisée en ce que** le dispositif de transport (3) comprend un lit de broches de support, déplaçable simultanément avec la portion de mâchoire mobile.

6. Machine de mise en place de composants (1) selon l'une des revendications précédentes, **caractérisée en ce que** les moyens de support (18, 20) comprennent deux crêtes s'étendant dans la direction X.

7. Machine de mise en place de composants (1) selon la revendication 6, **caractérisée en ce que** la distance entre les crêtes est ajustable.

8. Procédé pour transporter des cartes de circuit imprimé (5) par rapport à un châssis au moyen d'une poutre de transport (6) dans une direction X, moyennant quoi au moins une carte de circuit imprimé est déplacée au moyen de la poutre de transport (6) à partir d'une position initiale dans une direction X positive vers une direction prédéterminée, après quoi la poutre de transport (6) est abaissée par rapport à la carte de circuit imprimé dans une direction Z négative sur une distance prédéterminée, la poutre de transport 6 est déplacée dans la direction X négative vers la position initiale et la poutre de transport (6) est déplacée à nouveau dans la direction Z positive sur la distance prédéterminée, **caractérisé en ce que** le mouvement de la poutre de transport (6) dans la direction X négative, ainsi que la direction Z, est partiellement simultané.

9. Procédé selon la revendication 8, **caractérisé en ce que** le mouvement de la poutre de transport (6) dans la direction X négative commence dès que la poutre de transport (6) a été déplacée dans la direction Z négative sur une distance de sécurité mais avant que la poutre de transport (6) n'ait été déplacée dans la direction Z négative sur la distance prédéterminée.

10. Procédé selon la revendication 8, **caractérisé en ce que** le mouvement de la poutre de transport (6) dans la direction Z positive est commencée avant que la poutre de transport (6) ne se trouve dans la position initiale dans la direction X, mais la poutre de transport (6) sera déplacée à partir d'une distance de sécurité vers la position initiale dans la direction Z uniquement après que la poutre de transport (6) ait atteint la position X initiale.

11. Procédé selon l'une des revendications précédentes 9 ou 10, **caractérisé en ce que** la distance de sécurité est ajustable.
